# EUROPÄISCHE PATENTSCHRIFT

(11) **EP 2 452 435 B1**
(45) Veröffentlichungstag und Bekanntmachung des Hinweises auf die Patenterteilung: **11.10.2017**
(21) Anmeldenummer: 10731463.5
(22) Anmeldetag: 02.07.2010
(51) Int. Cl.: H03K 17/96, H01H 13/00, H01H 13/702

(54) **TASTSCHALTER MIT KAPAZITIVER TASTENERKENNUNG**
PUSH-BUTTON SWITCH HAVING CAPACITIVE TOUCHING DETECTION
TOUCHE À EFFLEUREMENT À RECONNAISSANCE CAPACITIVE DE LA TOUCHE

(30) Priorität: 10.07.2009 DE 102009032634
(43) Veröffentlichungstag der Anmeldung: 16.05.2012
(73) Patentinhaber: TRW Automotive Electronics & Components GmbH, 78315 Radolfzell (DE)
(72) Erfinder: REISE, Wulf, 87462 Konstanz (DE)
(74) Vertreter: Prinz & Partner mbB
(86) Internationale Anmeldenummer: PCT/EP2010/004016
(87) Internationale Veröffentlichungsnummer: WO 2011/003555

(56) Entgegenhaltungen:
- EP-A1- 1 635 366
- DE-A1- 19 839 811
- DE-T2- 69 121 858
- JP-A- 2008 282 724
- US-A1- 2008 257 707
- US-A1- 2009 128 511

## Beschreibung

Die Erfindung betrifft einen Tastschalter nach dem Oberbegriff des Anspruchs 1, bei dem sowohl eine Betätigung der Taste als auch eine Berührung der Taste erfasst wird.

Derartige Tastschalter werden beispielsweise in Telefon-Tastaturen oder Bedienfeldern mit mehreren Tasten eingesetzt.

Es sind Tastschalter bekannt, die eine elastische Schaltmatte aufweisen, z.B. aus der DE 198 39 811 A1 oder aus der gattungsgemäßen JP 2008 282724 A, die auf einen darunterliegenden Kontakt auf einer Leiterplatte einwirkt und so auf mechanische Weise einen Schaltkreis schließt, wenn die Taste betätigt wird. Die Berührungserkennung der Taste kann hingegen kapazitiv erfolgen, wobei beispielsweise eine Sensorfläche an der Innenseite der Tastenkappe angebracht ist, welche über Schleifkontakte oder Leitungen mit einer Auswerteelektronik verbunden ist. Dabei ist nachteilig, dass die Sensorfläche der Bewegung der Taste folgen muss und die elektrischen Verbindungen prozesstechnisch sehr aufwendig und zudem fehleranfällig sind.

Die EP 1 635 366 A1 zeigt einen Tastschalter mit einer kapazitiven Berührungserkennung, bei dem an der Innenseite der Taste ein erster Kondensator ausgebildet ist, der abstehende Arme aufweist, die in berührungsfreier Überlappung mit einer von einer Leiterplatte senkrecht abstehenden Platte eines Übertragungskondensators sind, um eine Änderung des elektrischen Feld des ersten Kondensators an eine Auswerteeinheit zu übertragen.

Die gattungsgemäße JP 2008-282724 A zeigt einen Tastschalter, bei der neben der oben beschriebenen Druck-Schaltfunktion eine kapazitive Schaltfunktion vorgesehen ist. Hierzu ist direkt unterhalb der mit einer Metallschicht versehenen Taste eine zusätzliche, flexible Elektrode zur Erfassung des kapazitiven Signals angeordnet.

Aufgabe der Erfindung ist es, einen eingangs genannten Tastschalter zu vereinfachen und dessen kostengünstigere Fertigung zu ermöglichen.

Zu diesem Zweck weist ein Tastschalter die Merkmale des Anspruchs 1 auf. Erfindungsgemäß ist also die Sensorfläche direkt auf der Leiterplatte angeordnet, sodass die Kontaktierung der Taste zur Signalauswertung entfallen kann. Die kapazitive Kopplung zwischen der kapazitiven Sensorfläche und der Berührfläche der Taste lässt sich bereits alleine dadurch erreichen, dass die Taste wenigstens abschnittsweise elektrisch leitfähig ausgebildet ist. Eine Kapazitätsänderung durch die Berührung der Taste kann damit von der kapazitiven Sensorfläche erfasst werden.

Die gesamte elektrische Kontaktierung sowie die Verbindung mit der Auswerteelektronik kann in diesem Fall vollständig über die Leiterplatte erfolgen. Eine Verbindung zwischen der Taste und der Leiterplatte mittels Schleifkontakten oder Kabeln kann entfallen.

Der Tastenkörper selbst besteht im vorliegenden Fall bevorzugt aus einem Kunststoff. Um die Taste leitfähig zu gestalten, wird die Taste vorzugsweise mit einer leitfähigen Beschichtung versehen. Beispielsweise kann die Taste verchromt oder mit einem anderen Metall überzogen sein, z.B. in einem galvanischen Verfahren. Es ist natürlich auch möglich, die Taste wenigstens abschnittsweise aus einem elektrisch leitfähigen Kunststoff zu fertigen, in den beispielsweise Kohlenstoffpartikel eingelagert sind.

Die Beschichtung ist vorzugsweise wenigstens an einer Berührfläche der Taste vorgesehen, um einen ausreichenden kapazitiven Effekt zu erzielen, wenn ein Benutzer die Taste berührt. Es ist jedoch vorteilhaft, die Taste vollständig elektrisch leitfähig zu machen, entweder durch das vollständige Überziehen mit einer elektrisch leitfähigen Beschichtung oder durch das Fertigen der gesamten Taste aus einem an sich elektrisch leitfähigen Kunststoff.

Bevorzugt erstreckt sich die leitfähige Beschichtung zumindest bis zu einem Bereich an der Unterseite der Taste, der in Kontakt mit der Schaltmatte ist.

Vorteilhaft ist die Schaltmatte auf ihrer Oberseite und/oder auf ihrer Unterseite elektrisch leitfähig ausgebildet, um die kapazitive Kopplung zu verstärken. Dies lässt sich beispielsweise durch eine leitfähige Lackierung erreichen. Insbesondere in Kombination mit einer leitfähigen Beschichtung der gesamten Taste ist dann die elektrisch leitende Verbindung zwischen der Berührfläche der Taste und der kapazitiven Sensorfläche lediglich durch die Dicke des Materials der Schaltmatte und den Abstand der Schaltmatte von der Sensorfläche unterbrochen. Von der Oberseite der Schaltmatte zu deren Unterseite besteht also vorzugsweise keine elektrisch leitende Verbindung, sondern nur eine kapazitive Kopplung. Es hat sich gezeigt, dass sich auf diese Weise eine sehr gute kapazitive Kopplung zwischen der kapazitiven Sensorfläche und der Berührfläche der Taste erreichen lässt.

Die Schaltmatte kann geschlossen ausgebildet sein, sodass sie keine Öffnungen auf ihrer Fläche aufweist. Hierdurch bewirkt die Schaltmatte auch einen Schutz der darunterliegenden Elemente vor Umwelteinflüssen, beispielsweise Feuchtigkeit, mechanischen Beschädigungen oder elektrostatischen Entladungen.

Zwischen der Leiterplatte und der Schaltmatte und über dem elektrischen Kontakt ist in einer bevorzugten Ausführungsform eine Schnappscheibe angeordnet, die bei der Ausübung der Druck-Schaltfunktion einen elektrischen Schaltkreis schließt, so wie dies von einer herkömmlichen Konstruktion eines Tastschalters mit einer Schaltmatte bekannt ist.

Anstatt einer Schnappscheibe kann auch eine bekannte Mäander/Kontaktpillen-Kombination zur Verwirklichung der Druck-Schaltfunktion vorgesehen sein.

Die Kontaktanordnung auf der Leiterplatte kann beispielsweise so gewählt sein, dass der elektrische Kontakt der Druck-Schaltfunktion von der kapazitiven Sensorfläche umgeben ist. Die beiden Kontakte sind elektrisch voneinander isoliert, um eine klare Trennung des auslösenden Signals zu erhalten. Es ist jedoch möglich, die Schnappscheibe auf dem gleichen Potenzial wie die Sensorfläche zu halten und eine Auswerteelektronik vorzusehen, die die bei Berührung oder Betätigung der Taste entstehenden Potenzialunterschiede unterscheiden und die Art der Betätigung bestimmen kann.

Weitere Merkmale und Vorteile der Erfindung ergeben sich aus der nachfolgenden Beschreibung eines Ausführungsbeispiels, in Verbindung mit den beigefügten Zeichnungen. In diesen zeigen:
- Figur 1 eine schematische Schnittansicht eines erfindungsgemäßen Tastschalters, und
- Figur 2 schematisch die Kontaktanordnung des Tastschalters aus Figur 1 in einer Draufsicht.

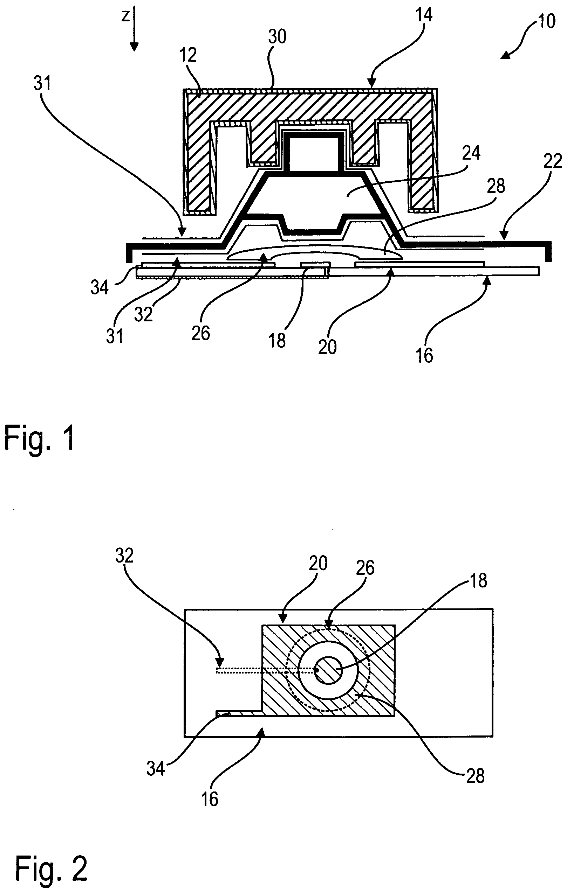

Die Figur 1 zeigt einen Tastschalter 10, der beispielsweise Teil einer Tastatur mit mehreren gleichartigen oder unterschiedlichen Tastschaltern sein kann. Der Tastschalter 10 kann auch in einem Bedienfeld mit einer oder mehreren Tasten eingesetzt werden, beispielsweise in einem Telefon oder in einem Bedienfeld in einer Fahrzeuginstrumententafel. Andere Anwendungen sind natürlich ebenfalls denkbar.

Der Tastschalter 10 weist eine Taste 12 auf, die in diesem Beispiel aus einer einstückig ausgebildeten, aus einem Kunststoff bestehenden Tastenkappe besteht. Die Taste 12 hat an ihrer Oberseite eine Berührfläche 14, an der ein Benutzer die Taste 12 mit einem Finger bedient, entweder um die Taste 12 nur zu berühren oder um die Taste 12 in z-Richtung zur Betätigung herunterzudrücken.

In z-Richtung unterhalb der Taste 12 liegt eine Leiterplatte 16, die mittig unter der Taste 12 einen elektrischen Kontakt 18 aufweist, und der Taste 12 in z-Richtung gegenüberliegend eine kapazitive Sensorfläche 20, die den elektrischen Kontakt 18 konzentrisch umgibt, wie in Figur 2 dargestellt ist.

Zwischen der Leiterplatte 16 und der Taste 12 ist eine Schaltmatte 22 angeordnet, die sich als geschlossene Fläche über die Leiterplatte 16 erstreckt, wobei vorzugsweise für sämtliche Tasten 12 in der Tastatur oder im Bedienfeld eine einzige, flächig durchgängige Schaltmatte 22 vorgesehen ist. Im Bereich der Taste 12 weist die Schaltmatte 22 einen Schaltdom 24 auf, der geometrisch so an die Form der Unterseite der Taste 12 angepasst ist, dass die Taste 12 auf dem Schaltdom 24 sicher verrastet ist. Die genaue Gestaltung kann von beliebigen bekannten Schaltmatten übernommen werden.

Zwischen der Schaltmatte 22, genauer gesagt zwischen dem Schaltdom 24, und der Leiterplatte 16 bzw. dem elektrischen Kontakt 18 ist eine Schnappscheibe 26 so angeordnet, dass ihre Wölbung vom elektrischen Kontakt 18 weg zeigt. Die Schnappscheibe 26 ist so ausgebildet und angeordnet, dass ihr Mittelpunkt über dem elektrischen Kontakt 18 liegt, während ihr Randbereich 28 über der kapazitiven Sensorfläche 20 angeordnet ist. Ihr Mittelpunkt ist vom elektrischen Kontakt 18 beabstandet.

Die Taste 12 ist elektrisch leitfähig gestaltet. Im gezeigten Beispiel ist sie vollständig mit einer metallischen Beschichtung 30, beispielsweise einer Chromschicht, überzogen.

Im Bereich der Taste 12 ist die Schaltmatte 22 sowohl an ihrer Oberseite als auch an ihrer Unterseite mit einer elektrisch leitfähigen Beschichtung 31 versehen. Es besteht also eine durchgehende elektrisch leitfähige Verbindung von der Berührfläche 14 der Taste 12 zur leitfähigen Beschichtung 31 der Oberseite der Schaltmatte 22 (in der Zeichnung sind die Taste 12 und die Schaltmatte 22 aus Gründen der Darstellung mit Abstand dargestellt). Die Beschichtung im Bereich der Unterseite der Schaltmatte 22 ist auch über der kapazitiven Sensorfläche 20 auf der Leiterplatte 16 angeordnet, wie in Figur 1 zu erkennen ist. Auf diese Weise wird eine kapazitive Kopplung zwischen der Berührfläche 14 und der kapazitiven Sensorfläche 20 erreicht, mittels derer durch Änderung der Kapazität bzw. des Potenzials an der kapazitiven Sensorfläche 20 eine Berührung der Taste 12 erkannt werden kann. Diese Erkennung wird von einer nicht gezeigten Auswerteelektronik vorgenommen. Diese Auswerteelektronik kann so ausgelegt sein, dass sie auch gleichzeitig eine konventionelle Tastenbetätigung durch Drücken in z-Richtung über die Druck-Schaltfunktion erkennt und auswertet.

Für die Druck-Schaltfunktion drückt der Benutzer die Taste 12 beispielsweise durch Druck auf die Berührfläche 14 in z-Richtung herunter, sodass der Schaltdom 24 auf den Mittelpunkt der Schnappscheibe 26 drückt und diese in z-Richtung durchbiegt, sodass der mittlere Bereich der Schnappscheibe 26 den elektrischen Kontakt 18 berührt. Gleichzeitig wird der Randbereich 28 auf die kapazitive Sensorfläche 20 gedrückt, sodass ein Stromfluss zwischen der kapazitiven Sensorfläche 20 und dem elektrischen Kontakt 18 ermöglicht ist. Das Schließen dieses Schaltkreises wird von der Auswerteelektronik detektiert und als Tastenbetätigung interpretiert. Der elektrische Kontakt 18 ist durch die Leiterplatte hindurch mit einer Leiterbahn 32 auf der Unterseite der Leiterplatte 16 kontaktiert, wie in Figur 2 dargestellt ist. Der Anschluss der kapazitiven Sensorfläche 20 erfolgt hingegen über eine Leiterbahn 34 auf der Oberseite der Leiterplatte 16.

Sowohl der elektrische Kontakt 18 als auch die kapazitive Sensorfläche 20 können durch Kupferflächen auf der Leiterplatte 16 gebildet sein, es ist aber auch möglich, an dieser Stelle eine Goldbeschichtung vorzusehen, um einer Korrosion vorzubeugen.

Es ist möglich, die Taste 12 nur abschnittsweise leitfähig auszubilden, wobei vorzugsweise eine Leitfähigkeit im Bereich der Berührfläche 14 vorgesehen ist. Vorteilhaft ist auch eine Leitfähigkeit an der Unterseite der Taste 12. Die Leitfähigkeit kann durch Vorsehen einer elektrisch leitfähigen Beschichtung, beispielsweise eine Verchromung oder Beschichtung mit einem anderen Metall, erreicht werden, aber auch dadurch, dass die Taste ganz oder teilweise aus einem an sich elektrisch leitfähigen Kunststoff besteht.

## Patentansprüche

1. Tastschalter mit
einer Druck-Schaltfunktion zur Erkennung einer Tastenbetätigung und
einer kapazitiven Sensorfunktion zur Erkennung einer Tastenberührung,
mit einer wenigstens abschnittsweise elektrisch leitfähigen Taste (12), eine Leiterplatte (16), die wenigstens einen elektrischen Kontakt (18) aufweist, über den durch Herunterdrücken der Taste (12) über eine zwischen der Taste (12) und der Leiterplatte (16) angeordnete Schaltmatte (22) auf mechanische Weise ein Stromkreis geschlossen wird, **dadurch gekennzeichnet, dass** die Leiterplatte (16) wenigstens eine der Taste (12) mit Abstand gegenüberliegende kapazitive Sensorfläche (20) aufweist,
wobei eine kapazitive Kopplung zwischen der Taste (12) und der Sensorfläche (20) besteht.

2. Tastschalter nach Anspruch 1, **dadurch gekennzeichnet, dass** die Taste (12) mit einer leitfähigen Beschichtung (30) versehen ist.

3. Tastschalter nach Anspruch 2, **dadurch gekennzeichnet, dass** die Beschichtung (30) an einer Berührfläche (14) der Taste (12) vorgesehen ist.

4. Tastschalter nach einem der Ansprüche 2 und 3, **dadurch gekennzeichnet, dass** sich die leitfähige Beschichtung (30) bis zu einem Bereich an der Unterseite der Taste (12) erstreckt, der in Kontakt mit der Schaltmatte (22) ist.

5. Tastschalter nach einem der vorhergehenden Ansprüche, **dadurch gekennzeichnet, dass** die Schaltmatte (22) auf ihrer Oberseite und/oder auf ihrer Unterseite elektrisch leitfähig ausgebildet ist.

6. Tastschalter nach Anspruch 5, **dadurch gekennzeichnet, dass** keine elektrisch leitende Verbindung von der Oberseite der Schaltmatte (22) zur Unterseite der Schaltmatte (22) besteht.

7. Tastschalter nach einem der vorhergehenden Ansprüche, **dadurch gekennzeichnet, dass** die Schaltmatte (22) geschlossen ausgebildet ist.

8. Tastschalter nach einem der vorhergehenden Ansprüche, **dadurch gekennzeichnet, dass** über dem elektrischen Kontakt (18) zwischen der Leiterplatte (16) und der Schaltmatte (22) eine Schnappscheibe (26) angeordnet ist, die bei der Ausübung der Druck-Schaltfunktion einen elektrischen Schaltkreis schließt.

9. Tastschalter nach einem der vorhergehenden Ansprüche, **dadurch gekennzeichnet, dass** der elektrische Kontakt (18) von der kapazitiven Sensorfläche (20) umgeben ist.

## Claims

1. A pushbutton switch having
a pressure switching function to recognize a key actuation, and
a capacitive sensor function to recognize a key touch,
comprising an at least partly electrically conductive key (12), a printed circuit board (16) which includes at least one electrical contact (18) by means of which an electric circuit is closed in a mechanical manner by depressing the key (12) via a switching mat (22) arranged between the key (12) and the printed circuit board (16), **characterized in that** the printed circuit board (16) has at least one capacitive sensor surface (20) located opposite to and at a distance from the key (12),
with a capacitive coupling existing between the key (12) and the sensor surface (20).

2. The pushbutton switch according to claim 1, **characterized in that** the key (12) is provided with a conductive coating (30).

3. The pushbutton switch according to claim 2, **characterized in that** the coating (30) is provided at a touch surface (14) of the key (12).

4. The pushbutton switch according to either of claims 2 and 3, **characterized in that** the conductive coating (30) extends as far as to an area on the lower side of the key (12) which is in contact with the switching mat (22).

5. The pushbutton switch according to any of the preceding claims, **characterized in that** the switching mat (22) is configured to be electrically conductive on its upper side and/or on its lower side.

6. The pushbutton switch according to claim 5, **characterized in that** no electrically conducting connection exists from the upper side of the switching mat (22) to the lower side of the switching mat (22).

7. The pushbutton switch according to any of the preceding claims, **characterized in that** the switching mat (22) is of a closed design.

8. The pushbutton switch according to any of the preceding claims, **characterized in that** a snap disk (26) is arranged above the electrical contact (18), between the printed circuit board (16) and the switching mat (22), the snap disk (26) closing an electric switching circuit when the pressure switching function is exercised.

9. The pushbutton switch according to any of the preceding claims, **characterized in that** the electrical contact (18) is surrounded by the capacitive sensor surface (20).

## Revendications

1. Interrupteur à bouton-poussoir, comprenant
une fonction de commutation par pression pour reconnaître un actionnement d'une touche et
une fonction sensorielle capacitive pour reconnaître un contact d'une touche,
comprenant une touche (12) électriquement conductrice au moins par tronçons, une carte de circuits imprimés (16) qui présente au moins un contact électrique (18) au moyen duquel un circuit électrique est fermé de manière mécanique par l'intermédiaire d'une natte de commutation (22) agencée entre la touche (12) et la carte de circuits imprimés (16) en pressant la touche (12), **caractérisé en ce que** la carte de circuits imprimés (16) présente au moins une surface de capteur capacitive (20) agencée à distance en face de la touche (12),
un couplage capacitif existant entre la touche (12) et la surface de capteur (20).

2. Interrupteur à bouton-poussoir selon la revendication 1, **caractérisé en ce que** la touche (12) est pourvue d'un revêtement conducteur (30).

3. Interrupteur à bouton-poussoir selon la revendication 2, **caractérisé en ce que** le revêtement (30) est prévu sur une surface de contact (14) de la touche (12).

4. Interrupteur à bouton-poussoir selon l'une des revendications 2 et 3, **caractérisé en ce que** le revêtement conducteur (30) s'étend jusqu'à une zone sur la face inférieure de la touche (12) qui est en contact avec la natte de commutation (22).

5. Interrupteur à bouton-poussoir selon l'une des revendications précédentes, **caractérisé en ce que** la natte de commutation (22) est réalisée de manière électriquement conductrice sur sa face supérieure et/ou sur sa face inférieure.

6. Interrupteur à bouton-poussoir selon la revendication 5, **caractérisé en ce qu'**il n'existe aucune liaison électriquement conductrice de la face supérieure de la natte de commutation (22) à la face inférieure de la natte de commutation (22).

7. Interrupteur à bouton-poussoir selon l'une des revendications précédentes, **caractérisé en ce que** la natte de commutation (22) est réalisée fermée.

8. Interrupteur à bouton-poussoir selon l'une des revendications précédentes, **caractérisé en ce qu'**un disque à encliquetage (26) est agencé au-dessus du contact électrique (18) entre la carte de circuits imprimés (16) et la natte de commutation (22), lequel ferme un circuit de commutation électrique lorsque la fonction de commutation par pression est exercée.

9. Interrupteur à bouton-poussoir selon l'une des revendications précédentes, **caractérisé en ce que** le contact électrique (18) est entouré par la surface de capteur capacitive (20).
